# EUROPÄISCHE PATENTANMELDUNG

(11) **EP 4 462 136 A1**
(43) Veröffentlichungstag der Anmeldung: **13.11.2024**
(21) Anmeldenummer: 23172699.3
(22) Anmeldetag: 11.05.2023
(51) Int. Cl.: G01R 29/08, G01R 29/12

(54) **SYSTEM UND ANORDNUNG ZUR MESSUNG EINES EXTERNEN ELEKTRISCHEN FELDES**

(71) Anmelder: Siemens Aktiengesellschaft, 80333 München (DE)
(72) Erfinder: Raab, Oliver, 94496 Ortenburg (DE); Santos Wilke, Hans, 85599 Parsdorf (DE)
(74) Vertreter: Siemens Patent Attorneys

(57) **Zusammenfassung**

Die vorliegende Erfindung betrifft ein System und eine Anordnung zur Messung eines externen elektrischen Feldes. Das System weist ein mikroelektromechanisches System auf oder ist als mikroelektromechanisches System (MEMS) ausgebildet. Das System weist eine Sensorelektrodenanordnung von wenigstens zwei Elektroden (13) auf einem Elektrodenträger (15) auf, welche Elektroden (13) mittels elektrischer Durchkontaktierungen (12) auf der elektrodenabgewandten Seite des Elektrodenträgers (15) kontaktierbar sind. Das System ist bevorzugt auf einem Schaltungsträger (20) angeordnet.

## Beschreibung

Die vorliegende Erfindung betrifft ein System und eine Anordnung zur Messung eines externen elektrischen Feldes.

### Stand der Technik:

Aus dem Stand der Technik, beispielsweise aus der DE 10 2010 035 381 A1 und der DE 10 2008 052 477 A1, ist ein Verfahren zur berührungslosen Spannungsmessung bekannt: Das Prinzip des MEMS-Voltmeters, auch bezeichnet als mikroelektromechanische Feldmühle, beruht auf einer Messung der zeitlichen Veränderung einer elektrischen Kapazität mittels eines mikroelektromechanischen Systems (MEMS). Insbesondere die beweglichen Bauteile einer mikroelektromechanischen Feldmühle liegen in der Größenordnung von 1 bis 1000 Mikrometer. Die zeitliche Veränderung der Kapazität wird mechanisch mit einem elektrischen, elektrostatischen oder thermischen Aktor herbeigeführt. Um die Veränderung der Kapazität zu messen, wird ein Verschiebungsstrom durch einen Strom-Spannungs-Wandler erfasst und hierdurch ein Messsignal generiert. Der Einfluss der zu messenden elektrischen Spannung auf das Messergebnis wird dadurch eliminiert, dass die Spannung konstante Anteile enthält und der Strom-Spannungs-Wandler während der Schaltflanken der Spannung abgetastet wird. So kann eine Impulsantwort auf Spannungsänderungen der zu messenden Spannung, die auch auf den Messkondensator wirken, ausgeblendet werden. Es wird die Eigenschaft des kapazitiven Messprinzips genutzt, dass ein Signal nur detektiert werden kann, wenn sich am Kondensator Ladungen verschieben, die einen Verschiebungsstrom I(t) initiieren. Hierfür gilt die Gleichung I(t) = dC/dt·U + dU/dt.C, wobei C die Kapazität des Kondensators ist und U die am Kondensator anliegende Spannung. Die Kapazität des Kondensators, beziehungsweise die Kapazität zwischen einem Messobjekt, beispielsweise einem stromführenden Leiter, und dem Sensor, also dem MEMS-Voltmeter, kann durch Änderung der Fläche der Kondensatorplatten, insbesondere durch Einschieben von Blenden in den Kondensatorspalt, durch Änderung des Abstandes der Kondensatorplatten oder durch Änderung der relativen Dielektrizitätskonstante des zwischen den Platten befindlichen Mediums geändert werden.

Während bei einem makroskopischen Aufbau der elektrischen Feldmühle die Flächen der Elektroden um Größenordnungen größer sind als die Flächen der Zuleitungen zwischen Elektroden und einer zugehörigen Messschaltung, liegen bei einer mikroelektromechanischen Feldmühle, auch MEMS-Voltmeter genannt, hingegen die Flächen der Elektroden und der Verschaltung in derselben Größenordnung. Demnach fallen bei einem makroskopischen Aufbau einer elektrischen Feldmühle auch Störsignale, wie beispielswiese das Übersprechen vom Antrieb der Feldmühle oder ein Einkoppeln des externen Feldes über Flächen, welche durch den oben genannten Schirm nicht vollständig abgeschirmt sind, nicht wesentlich ins Gewicht, jedoch schon bei einem MEMS-Voltmeter. Abhängig von den verschiedenen eingesetzten Technologien können die Flächen der Elektroden einer Feldmühle in einem mikroelektromechanischen System MEMS sogar deutlich kleiner sein als die freiliegenden Zuleitungen auf dem darunterliegenden Schaltungsträger, wie beispielsweise Leiterbahn, Bonddraht, Durchführung, etc. Die mikroelektromechanische Feldmühle ist daher durch ihre Anbindung auf einem Schaltungsträger in Relation zu ihren Elektroden deutlichen Störsignalen ausgesetzt.

Folglich stellt es sich als technisch erforderlich dar, eine verbesserte Lösung vorzuschlagen, welche die aus dem Stand der Technik bekannten Nachteile vermeidet. Insbesondere soll die vorzuschlagende Lösung eine verlässliche berührungslose Messung eines externen elektrischen Felds mittels einer mikroelektromechanischen Feldmühle ermöglichen.

Diese Aufgabe wird durch die Merkmale des unabhängigen Patentanspruchs 1, sowie durch die Merkmale des Patentanspruchs 7 gelöst. Vorteilhafte Ausgestaltungen der Erfindung sind Gegenstand der Unteransprüche.

Das erfindungsgemäße System zur Messung eines externen elektrischen Feldes umfasst eine Sensorelektrodenanordnung von wenigstens zwei Elektroden auf einem Elektrodenträger, welche Elektroden mittels elektrischer Durchkontaktierungen auf der elektrodenabgewandten Seite des Elektrodenträgers kontaktierbar sind. Durch die rückseitige Kontaktierbarkeit entfallen vorteilhaft vorderseitig freiliegenden Flächen, welche Störungsempfindlichkeiten aufweisen könnten. Auch die Durchkontaktierung durch den Elektrodenträger selbst sind insbesondere durch die Sensorelektrodenanordnung des Messystems vom zu messenden externen elektrischen Feld abgeschirmt. Zweckdienlicherweise handelt es sich um ein System zur berührungslosen Spannungsmessung welches dem Prinzip der elektrischen Feldmühle folgt.

Bei den zu bestimmenden externen elektrischen Feldern handelt es sich bevorzugt um Felder unter Spannung stehender elektrischer Leiter. Diese elektrischen Leiter können unter Gleichspannung oder Wechselspannung stehen. Die Feldstärke des von diesem elektrischen Leiter ausgehenden Feldes steht dann in proportionaler Beziehung zur Spannung. Die Spannung kann somit kontaktlos bestimmt werden.

Insbesondere umfasst das erfindungsgemäße System ein mikro-elektromechanisches System (MEMS) oder ist das erfindungsgemäße System als mikroelektromechanisches System ausgebildet. Dies hat den Vorteil, eine platz- und energiesparende Lösung eines E-Feld-Sensors anzugeben, welcher gegenüber störenden Einflüssen, insbesondere des zu messenden externen elektrischen Feldes, minimal unempfindlich ist, da nur der Elektrodenträger mit dem Messystem, insbesondere dem Voltmeter, dem zu messenden externen elektrischem Feld zugewandt ist. Ein weiterer Vorteil ist, dass keine Abschirmungen mittels leitfähiger Abdeckungen gegenüber dem zu messenden externen Feld notwendig sind. Durch die rückseitige Kontaktierung entfallen alle vorderseitig freiliegenden Flächen und auch die Durchkontaktierung durch den Schaltungsträger selbst ist durch den MEMS abgeschirmt.

Diese Lösung hat den Vorteil, den Einfluss der im Verhältnis zu den Elektroden sehr deutlichen Störsignalen zu verringern. Unter Störsignalen im Kontext dieser Anmeldung sind insbesondere ungewollte kapazitive Kopplungen zu verstehen, welche absolut betrachtet zwar nicht größer oder gar kleiner sind als bei einer makroskopischen Feldmühle sind, relativ zu den Sensorflächen der mikroelektromechanischen Feldmühle, also den Elektrodenflächen, sind sie aber doch deutlich größer. Diese ungewollte kapazitive Kopplung kann je nach Ausgestaltung im Bereich von einigen wenigen bis einigen hundert Femtofarad liegen. Bei der vorgeschlagenen Lösung werden diese Werte reduziert, ohne die Messignale zu schwächen. Insbesondere ist die mikroelektromechanische Feldmühle ausgebildet als mikro-elektromechanisches Sensor zur Messung einer elektrischen Feldstärke eines externen elektrischen Feldes, aufweisend ein Substrat, auf dessen Oberfläche eine erste Elektrodenanordnung mit voneinander beabstandeten, parallel zueinander auf der Oberfläche verlaufenden und gemeinsam elektrisch kontaktierten Elektrodenstreifen und eine zweite Elektrodenanordnung mit voneinander beabstandeten, parallel zueinander auf der Oberfläche verlaufenden und gemeinsam elektrisch kontaktierten weiteren Elektrodenstreifen vorgesehen sind, eine Blende, die parallel zur besagten Oberfläche sowohl ausgerichtet als auch beweglich gelagert ist, wobei die Blende für die erste Elektrodenanordnung und für die zweite Elektrodenanordnung Schlitze aufweist, die in einer ersten Stellung der Blende die erste Elektrodenanordnung und in einer zweiten Stellung der Blende die zweite Elektrodenanordnung freilegen, einen Aktuator als mechanische Kopplung zwischen dem Substrat und der Blende, wobei die Elektrodenstreifen der ersten Elektrodenanordnung und die Elektrodenstreifen der zweiten Elektrodenanordnung in abwechselnder Reihenfolge hintereinander auf der Oberfläche angeordnet sind, und wobei sich die Elektrodenstreifen der einen Elektrodenanordnung jeweils in den Zwischenräumen zwischen den Elektrodenstreifen der anderen Elektrodenanordnung befinden. Das erfindungsgemäße System umfasst vorteilhafterweise einen Elektrodenträger, welcher elektrisch isolierend ausgestaltet ist und die Durchkontaktierungen sind vorteilhafterweise als Through-Glass-VIAs (TGVs) ausgestaltet. Beispielsweise ist der Elektrodenträger aus Glas oder weist eine Glasschicht auf. Der Elektrodenträger ist zweckdienlicherweise so ausgestaltet, dass die darauf angeordneten Sensorelektroden voneinander isoliert sind und zur Rückseite des Elektrodenträgers isoliert sind. Der Elektrodenträger dient als Substrat für das elektrische Messsystem, in diesem Fall das mikroelektromechanische Messsystem. Der Elektrodenträger umfasst demnach auch weitere elektrisch leitende Anbindungen z. B. Leiterbahnen oder Durchkontaktierungen, um das mikroelektromechanische Messsystem auf einen Schaltungsträger aufzubringen.

Alternativ zur Ausführung mit Glasanteil kann der Elektrodenträger auch elektrisch halbleitend ausgestaltet sein, solange eine ausreichende Isolation zu den Sensorelektroden gewährleistet ist. Beispielsweise kann als Elektrodenträger ein Siliziumwafer dienen. In dieser beispielhaften Ausführungsform des Sensorsystems können die Durchkontaktierungen als Through-Silicon-VIAs (TSVs) ausgestaltet sein. Die Verwendung eines siliziumbasierten Elektrodenträgers, z.B. eines Silizium-Wafers, hat den Vorteil einer Kombination mit integrierter Schaltung zu entwerfen.

Das erfindungsgemäße System zur Messung eines externen elektrischen Feldes umfasst als mikroelektromechanische Feldmühle neben den Sensorelektroden bevorzugt auch eine Ground Elektrode und eine Drive Elektrode. Bevorzugt werden auch diese Elektroden mittels elektrischer Durchkontaktierungen auf der den Elektroden abgewandten Seite des Elektrodenträgers kontaktierbar gemacht. Dies hat den Vorteil einer einheitlichen Herstellung der Durchkontaktierungen und der elektrischen Anbindung des Messsystems an einen Schaltungsträger. Mit dieser Variante des Systems kann für die Ankontaktierung und Anbindung an einen Schaltungsträger vollständig auf Bondpads und Bonddrähte verzichtet werden. Demnach sind die dem elektrischen Feld ausgesetzten elektrisch leitfähigen Teile des Systems minimiert und liegen gänzlich auf der elektrodenabgewandten Seite des Elektrodenträgers und sind somit maximal vom zu messenden elektrischen Feld abgeschirmt.

Die erfindungsgemäße Anordnung zur Messung eines externen elektrischen Feldes umfasst ein System gemäß der Erfindung zur Messung eines externen elektrischen Feldes angeordnet auf einem Schaltungsträger. Dies hat den Vorteil, dass das System direkt mit einer weiteren Auswerteelektronik verbunden sein kann, die dann bevorzugt auf dem Schaltungsträger bzw. auf der Rückseite des Schaltungsträgers, also auf der vom elektrischen Feld abgewandten Seite angeordnet ist.

Besonders bevorzugt erfolgt die elektrische Kontaktierung des Messsystems an den Schaltungsträger über die Durchkontaktierungen in dem Elektrodenträger. Besonders bevorzugt wird die an die Durchkontaktierungen im Elektrodenträger anschließende weitere Leiterbahnführung zum Schaltungsträger oder auf dem Schaltungsträger gegen das zu messende externe elektrische Feld abgeschirmt und weist dazu eine Abschirmung auf.

Besonders bevorzugt weist auch der Schaltungsträger Durchkontaktierungen auf, welche mit den Durchkontaktierungen des Elektrodenträgers elektrisch verbunden werden. Dies hat den Vorteil, dass die elektrische Anbindung des Systems zur Messung des elektrischen Feldes direkt auf die Rückseite des Schaltungsträgers erfolgt und alle leitfähigen Elemente der Mess- und Auswerteelektronik maximal durch Elektrodenträger und Schaltungsträger vom zu messenden elektrischen Feld abgeschirmt sind.

Zweckdienlicherweise ist dazu auch eine weitere Leiterbahnführung auf der Schaltungsträgerrückseite umfasst, welche insbesondere die Auswertelektronik anbindet.

Die hier angeführte Lösung ermöglicht also eine Strecke zwischen den Elektroden des mikroelektromechanischen Systems und der weiteren Elektronik auf dem Schaltungsträger auf ein Minimum zu reduzieren. Des Weiteren werden sämtliche offenen Elektrodenflächen der Vorderseite der dem elektrischen Feld zugewandten Seite des mikroelektromechanischen Messsystems vermieden und benötigen keine Schirmung außer die der Messschaltung selbst.

Die Kontaktierung des mikroelektromechanischen Messsystems zur Messung eines externen elektrischen Feldes an den Schaltungsträger findet demnach bevorzugt über dessen Rückseite statt. Diese Rückseite des Schaltungsträgers ist den Messelektroden und dem externen elektrischen Feld abgewandt und durch die Messschaltung selbst abgeschirmt. Eine weitere Leiterbahnführung, die nicht durch die Messschaltung, den Elektrodenträger oder den Schaltungsträger abgeschirmt ist, müsste separat davon abgeschirmt werden. Durch die Durchkontaktierungen bis zur Rückseite des Schaltungsträgers, werden solche Erfordernisse für zusätzliche Abschirmungen vermieden.

### Figurenbeschreibung:

Weitere Merkmale, Eigenschaften und Vorteile der vorliegenden Erfindung ergeben sich aus der nachfolgenden Beschreibung unter Bezugnahme auf die beiliegende Figuren 1 bis 4. Darin zeigen:
Fig.1 zeigt einen schematischen Schnitt durch ein MEMS-Voltmeter mit Bonddrähten
Fig.2 zeigt einen schematischen Schnitt durch ein MEMS-Voltmeter mit VIAs
Fig.3 zeigt schematisch die Funktionsweise des MEMS-Voltmeters
Fig.4 zeigt eine schematische Konstruktionszeichnung für ein MEMS-Voltmeter

In den Ausführungsbeispielen und Figuren können gleiche oder gleich wirkende Elemente jeweils mit den gleichen Bezugszeichen versehen sein. Die dargestellten Elemente und deren Grö-ßenverhältnisse untereinander sind grundsätzlich nicht als maßstabsgerecht anzusehen, vielmehr können einzelne Elemente, zur besseren Darstellbarkeit und/oder zum besseren Verständnis im Verhältnis größer dimensioniert dargestellt sein.

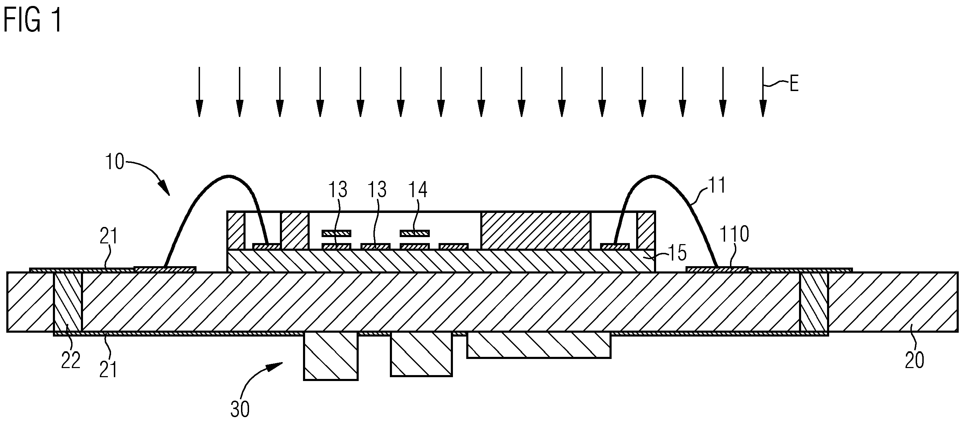

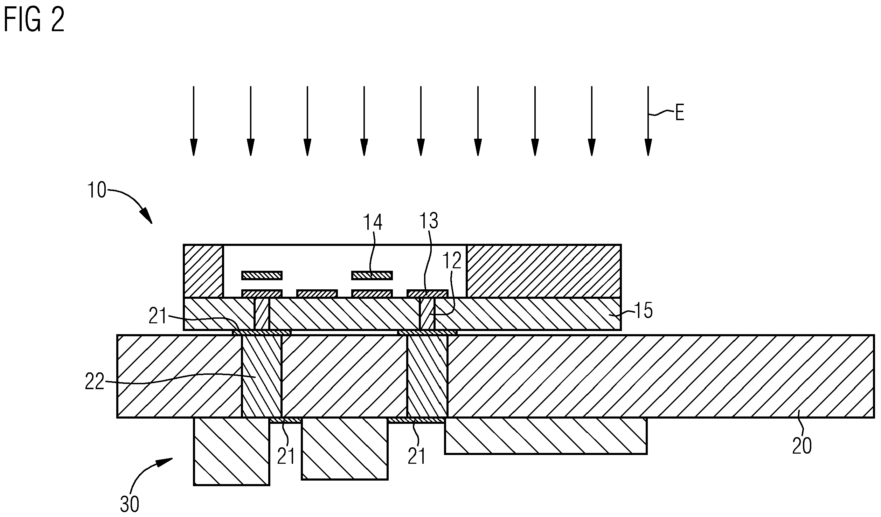

In der Figur 1 ist mit vertikalen Pfeilen dargestellt das zu messende elektrische Feld E, unter welchem das Messsystem 10 angeordnet ist. Das Messsystem 10 umfasst einen Elektrodenträger 15, auf dem die Messelektrodenanordnung 13 und die mikroelektromechanischen Shutter-Elektroden 14 angeordnet sind. Der Elektrodenträger 15 liegt auf einem Schaltungsträger 20 auf, dessen Rückseite eine weitere Elektronikanordnung 30 aufweist. Die elektrische Anbindung der Elektronikanordnung von Vorder- zur Rückseite des Schaltungsträgers 20 erfolgt über Leiterbahnen 21 und Durchkontaktierungen durch den Schaltungsträger 22. In Figur 1 im Gegensatz zu Figur 2 dargestellt ist die problematische Lösung der elektrischen Anbindung des Messsystems 10 mittels Bonddrähten 11 auf Bondpads 110. Diese sind in hohem Maße dem zu messenden elektrischen Feld E ausgesetzt. Wenn auch nicht maßstabsgetreu, so ist doch in der schematischen Zeichnung verdeutlicht, dass die Größenverhältnisse der elektrischen Leitungen 11, Bondpads 110 und auch Leiterbahnen 21 im Verhältnis zu den Sensorelektroden 13 einen großen Einfluss auf die Messempfindlichkeit und Messgenauigkeit haben.
Sämtliche weitere Elektronik 30 befindet sich auf der Rückseite des Schaltungsträgers 20 und ist dort von diesem externen Feld E abgeschirmt. Auf der Rückseite des Schaltungsträger 20 werden die Leiterbahnen bevorzugt entsprechend angeordnet, so dass ein minimales Übersprechen stattfindet. Leiterbahnen, Bonddrähte, Bondpads auf der Vorderseite werden möglichst kurzgehalten.

Demnach verdeutlicht Figur 2 den Abschirmungseffekt, wenn gemäß Erfindung die elektrische Anbindung der Messelektroden an den Schaltungsträger und weiter an die Auswerteelektronik 30 mittels Durchkontaktierungen 12 und 22 erfolgt. In der hier gezeigten schematischen Darstellung wird deutlich, dass auf der Vorderseite des Schaltungsträgers 20 nurmehr die Messelektroden 13 dem externen elektrischen Feld E ausgesetzt sind. Jegliche weitere elektrisch leitfähige Bahn, Leitung oder Fläche ist von dem Elektrodenträger 15, von der gesamten Messsystemanordnung 10, 20 abgeschirmt.

Die hier angeführte Lösung ermöglich es die Strecke zwischen den MEMS-Elektroden und der weiteren Elektronik auf dem Schaltungsträger auf ein Minimum zu reduzieren. Weiterhin werden sämtliche offene Elektrodenfläche der Vorderseite auf dem MEMS und auf dem Schaltungsträger vermieden und benötigen keine Schirmung außer die des MEMS oder des Schaltunsgträgers selbst. Der Vergleich der Abbildungen 1 und 2 verdeutlich dies.

Möglich sind aber auch VIAs für die Kontakte des Grounds und des Drive-Signals.

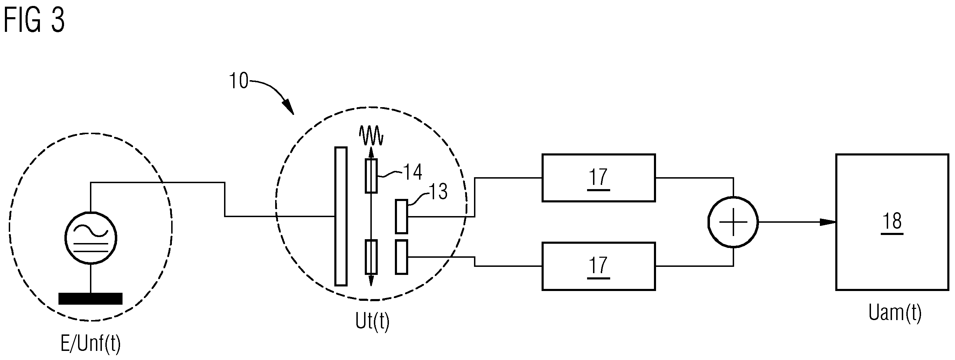

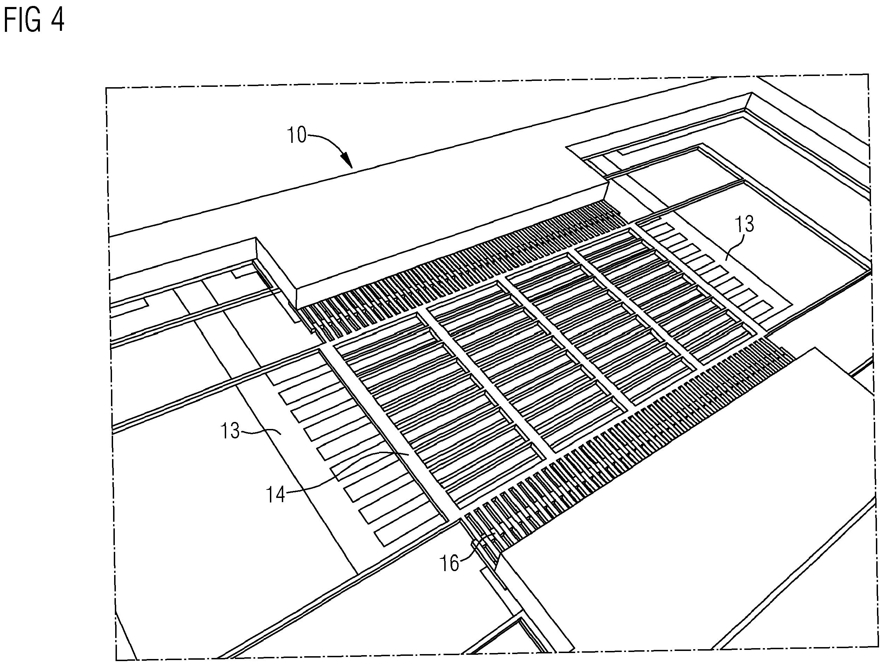

In Fig. 3 ist schematisch die Funktionsweise des MEMS-Voltmeters 10 dargestellt: Ein unter Spannung U stehendes Messobjekt 1 erzeugt ein elektrisches Feld E. Dieses elektrische Feld E wird mit Hilfe des MEMS-Voltmeters 10 berührungslos gemessen. Fig.4 zeigt eine schematische Konstruktionszeichnung für ein MEMS-Voltmeter 10. Es handelt sich um zwei elektrisch gegeneinander isolierte Kondensatorflächen 13, welche durch eine Verstärkerschaltung miteinander verbunden sind. Räumlich planparallel über diesen Kondensatorflächen 13, bzw. in Richtung der Quelle des zu messenden elektrischen Feldes E, ist eine schwingende Elektrode 14 angeordnet, welche auf einem neutralen Bezugspotential liegt. Diese schwingende Elektrode 14 schattet je nach Auslenkung eine der beiden Kondensatorflächen 13 vom zu messenden externen elektrischen Feld E ab. Relativ zur Stärke des externen elektrischen Feldes E fließt ein Strom bei jedem Schwingungsdurchgang der Elektrode 14. Die Vorzeichen der Ströme beider Kondensatorflächen sind dabei stets gegensätzlich. Die Differenz dieser Stromflüsse ist proportional zum elektrischen Feld E und kann durch die Verstärkerschaltung gemessen werden.

In Fig. 4 ist eine perspektivische Aufsicht auf eine schematische Konstruktionszeichnung eines MEMS-Chips 10 abgebildet, wie er in Schnittansicht in den Figuren 1 und 2 gezeigt ist. Zu sehen sind die Messelektroden 13 in Kammanordnung sowie die Shutterelektrode 14 und die elektromechanischen Aktuatoren 16.

### Bezugszeichenliste:

- E: Externes E-Feld
- 10: MEMS-Voltmeter
- 11: Bonddrähte
- 110: Bondpads
- 12: VIAs (vertical interconnect access)
- 13: MEMS-Elektroden
- 14: Elektrodenabschirmung, Shutter, beweglich
- 15: Elektrodenträger (z.B. Glassubstrat)
- 16: Comb Aktuator
- 17: I/U-Wandler
- 18: Analogsignal, Signalausgabe des Spannungssensors
- 20: Schaltungsträger
- 21: Leiterbahnen
- 22: VIAs (vertical interconnect access)
- 30: weitere Elektronik, z.B. Operationsverstärkerschaltung
- U_{nf}(t): modulierendes Nutzsignal
- Uₜ(t): unmodulierter Träger
- Uₐₘ(t): modulierter Träger

## Patentansprüche

1. System (10) zur Messung eines externen elektrischen Feldes (E), aufweisend eine Sensorelektrodenanordnung von wenigstens zwei Elektroden (13) auf einem Elektrodenträger (15), welche Elektroden (13) mittels elektrischer Durchkontaktierungen (12) auf der elektrodenabgewandten Seite des Elektrodenträgers (15) kontaktierbar sind.

2. System (10) nach Anspruch 1, welches ein mikroelektromechanisches System aufweist oder als mikroelektromechanisches System (MEMS) ausgebildet ist.

3. System (10) nach einem der vorstehenden Ansprüche, wobei der Elektrodenträger (15) elektrisch isolierend ausgestaltet ist die Durchkontaktierungen (12) als Through-Glass-VIAs (TGVs) ausgestaltet sind.

4. System (10) nach Anspruch 3, wobei der Elektrodenträger (15) Glas aufweist.

5. System (10) nach einem der vorstehenden Ansprüche 1 bis 3, wobei der Elektrodenträger (15) elektrisch halbleitend ausgestaltet ist und die Durchkontaktierungen (12) als Through-Silicon-VIAs (TSVs) ausgestaltet sind.

6. System (10) nach einem der vorstehenden Ansprüche, aufweisend eine Ground-Elektrode und/oder eine Drive-Elektrode, welche mittels elektrischer Durchkontaktierungen (12) auf der elektrodenabgewandten Seite des Elektrodenträgers (15) kontaktierbar sind.

7. Anordnung eines Systems (10) nach einem der vorstehenden Ansprüche auf einem Schaltungsträger (20).

8. Anordnung nach Anspruch 7, wobei die elektrische Kontaktierung des Systems (10) an den Schaltungsträger (20) über die Durchkontaktierungen (12) erfolgt.

9. Anordnung nach einem der vorstehenden Ansprüche 7 oder 8, wobei die an die Durchkontaktierungen (12) anschließende weitere Leiterbahnführung eine Abschirmung gegen das zu messende externe elektrische Feld (E ) aufweist.

10. Anordnung nach einem der vorstehenden Ansprüche 7 bis 9, wobei die Durchkontaktierungen (12) mit weiteren Durchkontaktierungen (22) durch den Schaltungsträger (20) verbunden sind.

11. Anordnung nach einem der vorstehenden Ansprüche 7 bis 10, wobei eine weitere Leiterbahnführung (21) auf der Schaltungsträgerrückseite umfasst ist.
